# EUROPEAN PATENT APPLICATION

(11) **EP 4 693 951 A1**
(43) Date of publication of application: **11.02.2026**
(21) Application number: 24889085.7
(22) Date of filing: 05.11.2024
(51) Int. Cl.: H04B 10/114, H04B 10/03, H01M 10/42, H05B 47/10, H05B 45/325, H02M 3/158

(54) **OPTICAL FEEDBACK COMMUNICATION METHOD AND BATTERY MANAGEMENT SYSTEM PERFORMING SAME**

(30) Priority: 09.11.2023 KR 20230154588; 12.09.2024 KR 20240125067
(71) Applicant: LG Energy Solution, Ltd., Seoul 07335 (KR)
(72) Inventor: KIM, Youngbeom, Daejeon 34122 (KR); YOON, Sunwoo, Daejeon 34122 (KR); JO, Yongmin, Daejeon 34122 (KR)
(74) Representative: Hoffmann Eitle
(86) International application number: PCT/KR2024/017278
(87) International publication number: WO 2025/100897

(57) **Abstract**

Disclosed is a battery management system including: a light receiving unit for generating a voltage based on light having communication information received from an external battery management system; a light emitting unit for transmitting the light having communication information to the external battery management system; and a control unit. The control unit determines a voltage value generated by the light receiving unit according to the intensity of the light received from the external battery management system, the voltage value being determined on the basis of the intensity of the light received from the external battery management system, and adjusts the intensity of the light transmitted from the light emitting unit, the intensity being adjusted on the basis of the determined voltage value.

## Description

### TECHNICAL FIELD

The present disclosure relates to an optical feedback communication method and a battery management system for performing the optical feedback communication method.

### BACKGROUND

Battery management systems (BMSs) are used to control batteries efficiently and smoothly. For example, a battery management system measures the current, voltage, or temperature of a battery equipped in a battery electric vehicle (BEV), an energy storage system (ESS), and other devices and systems using sensors, and appropriately utilizes these measured information to control the lifespan, performance, and safety of the battery, thereby ensuring that the battery operates at optimal performance.

In order to achieve the optimal performance of the battery, multiple battery management systems need to exchange data and various information with each other through wired and/or wireless communications.

### SUMMARY

### Technical Goals

The technical tasks to be achieved by the present example embodiments are not limited to the technical tasks described above, and other technical tasks may be inferred from the following example embodiments.

### Technical solutions

A battery management system according to an embodiment includes a light receiving unit configured to generate a voltage based on light received from an external battery management system and containing communication information, a light emitting unit configured to transmit light containing communication information to the external battery management system, and a control unit, wherein the control unit may be configured to check a voltage value of the voltage generated by the light receiving unit based on an intensity of the light received from the external battery management system and to adjust an intensity of the light transmitted from the light emitting unit based on the checked voltage value.

The control unit may control the intensity of the light transmitted from the light emitting unit to the external battery management system to increase when the intensity of the light received from the external battery management system decreases.

The control unit may adjust the intensity of the light transmitted from the light emitting unit to the external battery management system so that the checked voltage value is equal to a designated target voltage value.

The designated target voltage value may be determined based on communication consumption power between the battery management system and the external battery management system.

The control unit may include a first operational amplifier configured to compare the checked voltage value with the designated target voltage value and output a duty voltage signal, a pulse width modulation (PWM) logic circuit configured to determine a duty ratio for the duty voltage signal, a gate driver circuit connected to the PWM logic circuit and configured to control the duty ratio, a buck boost converter circuit connected to the gate driver circuit and configured to output a feedback voltage signal based on a driving voltage and the duty ratio, and a negative feedback circuit including a second operational amplifier and a MOSFET element to provide the feedback voltage signal to the light emitting unit.

The first operational amplifier may increase and output the duty voltage signal as a magnitude of a difference between the checked voltage value and the designated target voltage value increases.

The buck-boost converter circuit may increase and output the feedback voltage signal if the duty ratio increases.

The negative feedback circuit may provide the feedback voltage signal to the light emitting unit based on a current flowing through the MOSFET element.

The MOSFET element may be a PMOS element, and the second operational amplifier may apply the feedback voltage signal to a drain terminal of the PMOS element.

An optical feedback communication method of a battery management system according to an embodiment includes generating a voltage based on light received from an external battery management system and containing communication information, checking a voltage value of the voltage generated by a light receiving unit based on an intensity of the light received from the external battery management system, adjusting an intensity of light transmitted from a light emitting unit based on the checked voltage value, and transmitting light containing communication information to the external battery management system.

Details of the embodiments are included in the detailed description and drawings.

### Effects of the Invention

According to the optical feedback communication method of the present disclosure, even when degradation in communication performance between the battery management system and the external battery management system over time is sensed, the intensity of light used for communication between the battery management system and the external battery management system may be maintained at a constant level according to the optical feedback communication method to which a negative feedback method is applied, thereby ensuring that the communication state may be smoothly maintained.

Effects according to various embodiments of the present disclosure are not limited to the effects mentioned above, and other effects not mentioned will be clearly understood by those skilled in the art from the description of the claims.

### BRIEF DESCRIPTION OF THE DRAWINGS

The following drawings attached hereto exemplify embodiments of the present disclosure and serve to help further understand the technical idea of the present disclosure together with the detailed description of the disclosure to be described later. Therefore, the present disclosure should not be construed as being limited to the matters illustrated in the drawings.
FIG. 1 is a diagram illustrating the concept of a system that performs an optical feedback communication method between battery management systems according to an embodiment.
FIG. 2 is a block diagram illustrating a structure of a battery management system that performs optical feedback wireless communication according to an embodiment.
FIGS. 3a and 3b are diagrams generally illustrating an optical feedback process between a battery management system and an external battery management system according to an embodiment, respectively.
FIGS. 4a and 4b are diagrams illustrating a control unit of the battery management system according to an embodiment.
FIG. 5 is a flowchart illustrating an operation of the battery management system that performs optical feedback wireless communication according to an embodiment.
FIG. 6 is a block diagram illustrating a hardware configuration of the control unit included in the battery management system according to an embodiment.

In some of the accompanying drawings, corresponding components are given the same reference numerals. A person ordinarily skilled in the art will appreciate that the drawings illustrate elements simply and clearly and are not necessarily drawn to scale. For example, in order to aid understanding of various embodiments, the dimensions of some elements illustrated in the drawings may be exaggerated compared to other elements. In addition, elements that are useful or essential in commercially implementable embodiments but are known in the art may often not be described in order to avoid impeding the understanding of the spirit of various embodiments of the present disclosure.

### DETAILED DESCRIPTION

The terms used in embodiments have been selected from commonly used general terms as much as possible while considering the functions in the present disclosure, but these may vary depending on the intention of those skilled in the art, precedents, the emergence of new technologies, and others. Additionally, in certain cases, there are terms arbitrarily selected by the applicant, and in such cases, their meanings will be described in detail in the relevant description sections. Therefore, the terms used in the present disclosure should be defined based on the meanings of the terms and the overall contents of the present disclosure, rather than merely the names of the terms.

When a certain part is said to "include" a certain component throughout the specification, it means that other components may be further included unless specifically stated otherwise, rather than excluding other components.

The expression "at least one of *a, b,* and *c*" as used throughout the specification can encompass *"a* alone", *"b* alone", "*c* alone", *"a* and *b", "a* and *c", "b* and *c",* or "all of *a, b,* and *c".*

The term "terminal" referred to below may be implemented as a computer or portable terminal capable of connecting to a server or other terminals via a network. Here, the computer may include, for example, a notebook, desktop, laptop or others equipped with a WEB browser, and the portable terminal may include, for example, any type of handheld-based wireless communication devices that ensure portability and mobility, such as communication-based terminals such as International Mobile Telecommunication (IMT), Code Division Multiple Access (CDMA), Wideband Code Division Multiple Access(W-CDMA), and Long Term Evolution (LTE), smartphones, tablet PCs, and other similar devices.

Hereinafter, embodiments of the present disclosure will be described in detail with reference to the attached drawings so that those skilled in the art to which the present disclosure pertains can easily implement the present disclosure. However, the present disclosure may be implemented in various different forms and is not limited to the embodiments described herein.

A battery management system (BMS) may be installed, for example, in the unit of a battery pack, a battery module, and a battery cell. These battery management systems communicate with each other to ensure that the battery pack, battery module, and battery cell are managed to operate in a stable manner.

Among the communication methods between battery management systems, wireless communication has advantages in terms of not only communication quality but also system simplification. In such wireless communication between battery management systems, an optical communication method using, for example, a light-emitting diode as a light-emitting element and a light-receiving diode as a light-receiving element may be used. The optical communication method using these light-emitting and light-receiving elements has many advantages, but communication quality may deteriorate due to deterioration in light transmission ability caused by the aging of these elements, dust, condensation, and other factors. For example, when communication performance is reduced due to performance degradation resulting from the use of a photodiode, it may be difficult for the battery management system to sense this deterioration in communication performance and maintain communication performance.

Various embodiments of the present disclosure utilizes optical feedback to provide a battery management system and communication method that are capable of maintaining constant communication quality even when light transmission ability deteriorates due to the aging of elements, dust, or condensation.

Hereinafter, embodiments of the present disclosure will be described in detail with reference to the drawings.

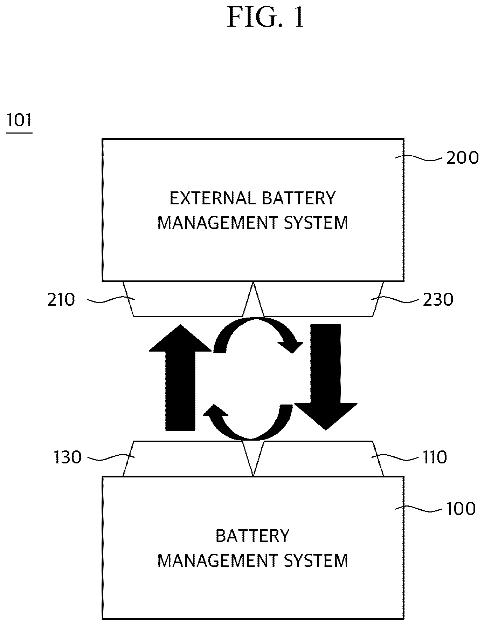

FIG. 1 is a diagram illustrating the concept of a system that performs an optical feedback communication method between battery management systems according to an embodiment.

Referring to FIG. 1, a system 101 that performs an optical feedback communication method according to an embodiment may include a battery management system (BMS)100 that performs optical feedback communication control and an external battery management system 200 that communicates with the battery management system 100.

The term "external battery management system 200" as used herein refers to a battery management system that is in a communication relationship with the battery management system 100 that performs optical feedback communication control according to various embodiments of the present disclosure, regardless of a physical location thereof. For example, it is assumed that communication is between the BMS of a battery pack and the BMS of a specific battery module included in that pack, and the BMS of the battery pack may be assumed to be the battery management system 100 and the BMS of the specific battery module may be assumed to be the external battery management system 200.

Various embodiments of the present disclosure are intended to maintain communication performance between the battery management system 100 and the external battery management system 200 through optical feedback. For example, the battery management system 100 according to various embodiments of the present disclosure proposes a method capable of maintaining communication performance by increasing the intensity of the light in a light emitting unit 130 of the battery management system 100 which is transmitted to the external battery management system 200 after the light transmitted from a light emitting unit 230 of the external battery management system 200 is received by a light receiving unit 110 of the battery management system 100, even when the intensity of light received at a light receiving unit 210 decreases due to the accumulated use of the light emitting unit 130, causing a decrease in the intensity of light received by the light receiving unit 210 of the external battery management system 200. Through this, various embodiments of the present disclosure utilizes an optical feedback control method and may maintain communication performance between the battery management system 100 and the external battery management system 200 through a negative feedback method, even when dust accumulates on each of the light emitting units 130, 230 and the light-receiving units 110, 210 as a communication period between the battery management systems increases.

Although the example described above assumes a case where the intensity of light decreases due to the accumulated use of the light emitting unit 130 of the battery management system 100, the various embodiments of the present disclosure are not limited to this, and, for example, may also be similarly applied to a case where the intensity of light decreases due to the accumulated use of the light emitting unit 230 of the external battery management system 200.

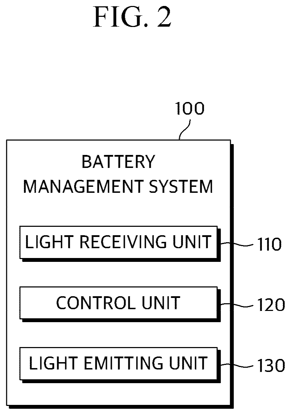

FIG. 2 is a block diagram illustrating a structure of a battery management system that performs optical feedback via wireless communication according to an embodiment.

Referring to FIG. 2, the battery management system 100, according to an embodiment may include the light receiving unit 110 that generates a voltage based on light containing communication information received from the external battery management system 200, a control unit 120, and the light emitting unit 130 that transmits the light containing communication information to the external battery management system 200. The battery management system 100 illustrated in FIG. 2 illustrates only components related to the present embodiment. Therefore, it will be understood by those skilled in the art related to the present embodiment that other general-purpose components may also be included, in addition to the components illustrated in FIG. 2.

In an embodiment, the light receiving unit 110 of the battery management system 100 may receive an optical signal (light) transmitted from the light emitting unit 230 of the external battery management system 200, and may generate a voltage based on the received light. The light receiving unit 110 of the battery management system 100 may include one or more photodiodes corresponding to semiconductor diodes, which function as a photodetector according to an embodiment. The photodiode included in the light receiving unit 110 may have a PN junction or a PIN structure, so that when light with sufficient photon energy is incident on the photodiode, mobile electrons and positively charged holes are generated, resulting in the generation of a photocurrent through the activity of the electrons. The current generated in this way may generate a voltage based on the intensity of the light when flowing through a resistor. Meanwhile, in the description of the present disclosure, the terms "optical signal" and "light" are used interchangeably herein with the same meaning.

In an embodiment, the control unit 120 may be configured to check (e.g., sense) the voltage value of a voltage, which is generated, by the light receiving unit 110, in response to an optical signal transmitted from the external battery management system 200 based on the intensity of light received from the external battery management system 200, and to adjust the intensity of light transmitted from the light emitting unit 130 to the external battery management system 200, based on the checked voltage value. For example, the control unit 120 of the battery management system 100 may control the intensity of light transmitted from the light emitting unit 130 to the external battery management system 200 to increase, when the intensity of the light received from the external battery management system 200 decreases. For example, the control unit 120 of the battery management system 100 may check the voltage value of a voltage generated by the light receiving unit 110, based on the intensity of the light received from the external battery management system 200, and may adjust the intensity of the light transmitted from the light emitting unit 130 to the external battery management system 200, so that the voltage value corresponding to the intensity of the light received from the external battery management system 200 is equal to a designated target voltage value. At this time, the designated target voltage value may be determined based on the communication consumption power between the battery management system 100 and the external battery management system 200 according to an embodiment, or may be determined based on the minimum power consumption required to maintain the wireless communication between the battery management system 100 and the external battery management system 200.

In an embodiment, the light emitting unit 130 of the battery management system 100 may transmit light containing communication information to the external battery management system 200. The light emitting unit 130 of the battery management system 100 may include one or more photodiodes corresponding to semiconductor diodes, which function as a photodetector, similar to the light receiving unit 110 described above, and may transmit light having an appropriate light intensity to the external battery management system 200, to perform optical feedback under control from the control unit 120 of the battery management system 100.

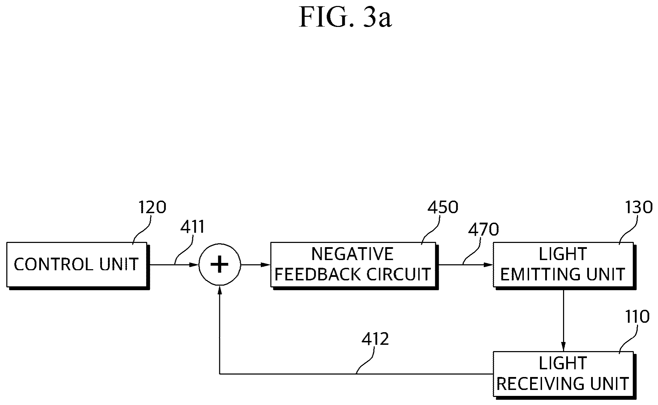

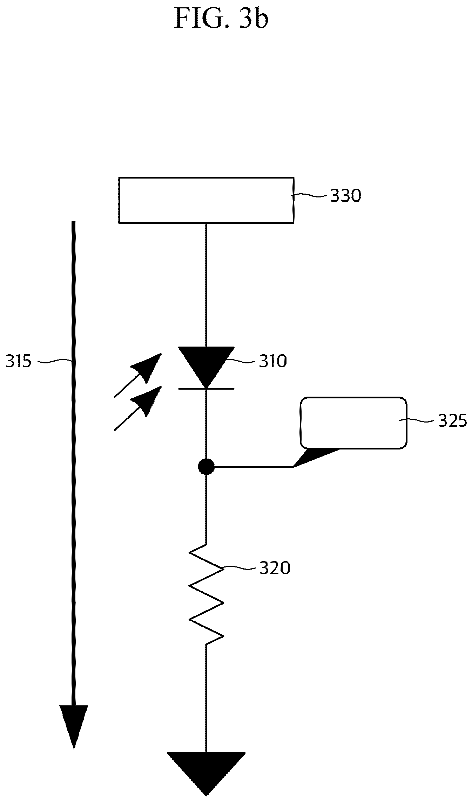

FIGS. 3a and 3b are diagrams illustrating an overall optical feedback process between the battery management system 100 and the external battery management system 200 according to an embodiment.

Referring to FIG. 3a, the overall optical feedback process within the battery management system 100 may be confirmed when the battery management system 100 and the external battery management system 200 exchange signals with each other according to an embodiment.

First, the control unit 120 of the battery management system 100 may generate a required target voltage value 411 based on communication power consumption used for communication between the battery management system 100 and the external battery management system 200, and may then compare the target voltage value 411 with a voltage value 412 which has been checked based on the light received by the light receiving unit 110 of the battery management system 100, to transmit the comparison result to a negative feedback circuit 450 within the control unit 120. The negative feedback circuit 450 may appropriately change the intensity of light transmitted from the light emitting unit 130 of the battery management system 100 to the external battery management system 200, through a current 470 that reflects a feedback voltage signal generated based on the comparison result between the target voltage value 411 set based on the communication consumption power in the control unit 120 and the voltage value 412 checked based on the light received by the light receiving unit 110. As a result of this negative feedback operation, the voltage value 412 of a voltage generated based on the light received from the external battery management system 200, received by the light receiving unit 110 of the battery management system 100, may be controlled to be equal to the target voltage value 411.

Through the negative feedback operation as described above, the battery management system 100 may ensure that the voltage value 412 checked by the light receiving unit 110 of the battery management system 100 is kept equal to the target voltage value 411, even when the strength of a wireless communication signal between the battery management system 100 and the external battery management system 200 weakens, leading to a reduction in the checked voltage value 412. The operation performed by each component in the above-described optical feedback process will be individually described below.

FIG. 3b is a diagram illustrating the overall process occurring within the external battery management system 200 during the process of the battery management system 100 receiving light from the external battery management system 200, according to an embodiment.

Referring to FIG. 3b, a photodiode 310 included in the light receiving unit 210 of the external battery management system 200 may receive light containing communication information from the light emitting unit 130 of the battery management system 100. When the intensity of light received by the light receiving unit 210 of the external battery management system 200 decreases due to, for example, dusts accumulating on a photodiode in the light emitting unit 130 of the battery management system 100 or dusts accumulating on the photodiode 310 included in the light receiving unit 210 of the external battery management system 200, a current 315 flowing through the photodiode 310 of the light receiving unit 210, driven by a driving voltage (VDD) 330, may be reduced. As the degree of voltage drop caused by a light receiving unit resistor 320 is reduced due to a reduction in the current 315 flowing through the photodiode 310 of the light receiving unit 210 of the external battery management system 200, a light receiving unit voltage 325 may also be reduced. A reduction in the light receiving unit voltage 325 of the external battery management system 200 may be transmitted to the light emitting unit 230 connected to the light receiving unit 210 of the external battery management system 200. As a result, the intensity of the light containing communication information, which is transmitted from the light emitting unit 230 of the external battery management system 200 and is received by the light receiving unit 110 of the battery management system 100, may decrease, and a voltage generated by the light receiving unit 110 of the battery management system 100 may also be lowered. Through these changes, the control unit 120 of the battery management system 100 may sense that the intensity of light used for communication between the battery management system 100 and the external battery management system 200 has weakened, and may control the light emitting unit 130 of the battery management system 100 to ensure that an appropriate intensity of light is transmitted to the external battery management system 200, through appropriate compensation.

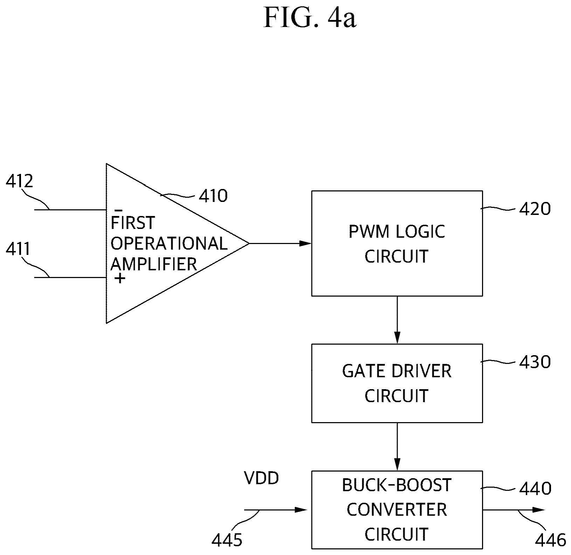

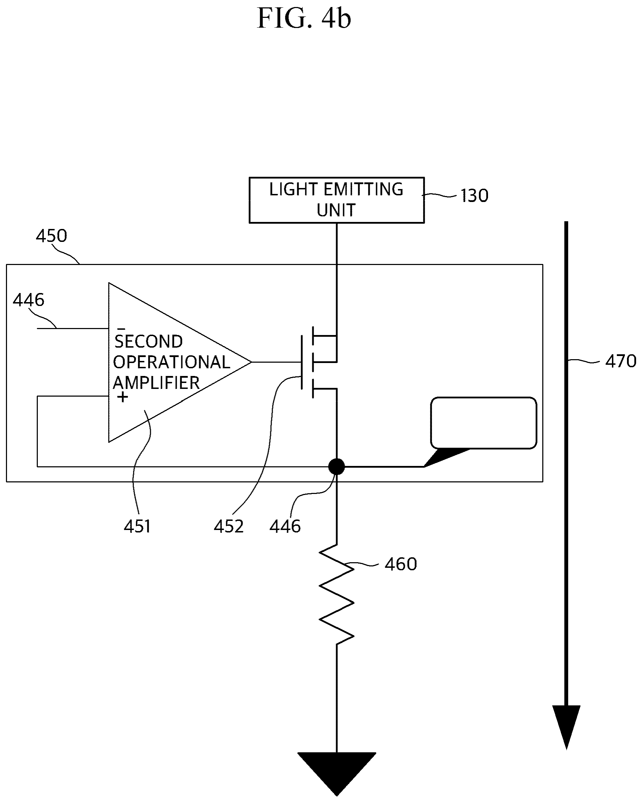

FIGS. 4a and 4b are diagrams illustrating the control unit 120 of the battery management system 100 according to an embodiment.

Referring to FIG. 4a, the control unit 120 according to an embodiment may check (sense) the voltage value of a voltage generated by the light receiving unit 110 based on the intensity of the light received from the external battery management system 200. According to an embodiment, the control unit 120 of the battery management system 100 may include a first operational amplifier 410, that checks the voltage value of a voltage generated based on the intensity of the light received from the external battery management system 200 and then compares the checked voltage value 412 with the designated target voltage value 411 to output a duty voltage signal. The control unit 120 may also include a pulse width modulation (PWM) logic circuit 420 that determines a duty ratio for a duty voltage signal, a gate driver circuit 430 that is connected to the PWM logic circuit 420 and controls the duty ratio, and a buck boost converter circuit 440 that is connected to the gate driver circuit 430 and outputs a feedback voltage signal 446 based on a driving voltage 445 and the duty ratio.

The first operational amplifier 410 included in the control unit 120 of the battery management system 100, according to an embodiment may output a duty voltage signal to be input to the PWM logic circuit 420 by taking, as an input, the voltage value 412 checked by the control unit 120 and the designated target voltage value 411. For example, the first operational amplifier 410 may increase and output the duty voltage signal as the magnitude of the difference between the checked voltage value 412 and the designated target voltage value 411 increases.

The PWM logic circuit 420 included in the control unit 120 of the battery management system 100, according to an embodiment, may modulate the pulse width of the duty voltage signal received from the first operational amplifier 410 to determine the duty ratio for the duty voltage signal, and may transmit the determined duty ratio to the gate driver circuit 430.

The gate driver circuit 430, included in the control unit 120 of the battery management system 100, according to an embodiment, may control the duty ratio determined by the PWM logic circuit 420. For example, when the duty voltage signal increases, the gate driver circuit 430 may increase the duty ratio based on the duty voltage signal.

The buck-boost converter circuit 440, included in the control unit 120 of the battery management system 100, according to an embodiment, may receive the duty ratio from the gate driver circuit 430 and may output a feedback voltage signal 446 based on the driving voltage 445 and the duty ratio. For example, the buck-boost converter circuit 440 may increase and output the feedback voltage signal 446 when the duty ratio for a signal received from the gate driver circuit 430 increases. By this operation, the buck-boost converter circuit 440 according to one of various embodiments of the present disclosure may output the feedback voltage signal 446 that is variable.

In an embodiment, when the intensity of the light containing communication information received from the external battery management system 200 decreases, a voltage generated by the light receiving unit 110 of the battery management system 100 may also decrease, and a duty voltage signal generated by the first operational amplifier 410 may increase. Thereby, when a duty ratio determined by the PWM logic circuit 420 connected to the first operational amplifier 410 increases, the buck-boost converter circuit 440 receives the increased duty ratio from the gate driver circuit 430 connected to the PWM logic circuit 420. As the duty ratio increases, the feedback voltage signal 446, which is an output value of the buck-boost converter circuit 440 driven by the driving voltage 445, may increase.

Referring to FIG. 4b, the control unit 120 of the battery management system 100, according to an embodiment, may include the negative feedback circuit 450, which includes a second operational amplifier 451 and a MOSFET element 452 to provide the previously generated feedback voltage signal 446 to the light emitting unit 130. For example, the negative feedback circuit 450 may provide the feedback voltage signal 446 to the light emitting unit 130 based on the current 470 flowing through the MOSFET element 452. Although not illustrated, it is assumed that a power source VDD is connected to the other end of the light emitting unit 130 connected to the MOSFET element 452.

For example, as described above in FIG. 4a, when the feedback voltage signal 446, which is an output value of the buck-boost converter circuit 440, increases, the current 470 flowing from the power source VDD to the MOSFET element 452 and a light emitting unit resistor 460 may increase according to an increase in the feedback voltage signal 446. In this way, the negative feedback circuit 450, included in the control unit 120 of the battery management system 100, may increase the intensity of light transmitted from the light emitting unit 130 to the external battery management system 200 through the current 470, that reflects the increased feedback voltage signal 446. At this time, the MOSFET element 452 may be a PMOS element according to an embodiment, and the second operational amplifier 451 may apply the feedback voltage signal 446 to a drain terminal of the PMOS element, but the embodiment of the negative feedback circuit 450 according to the present disclosure is not limited to the specific case.

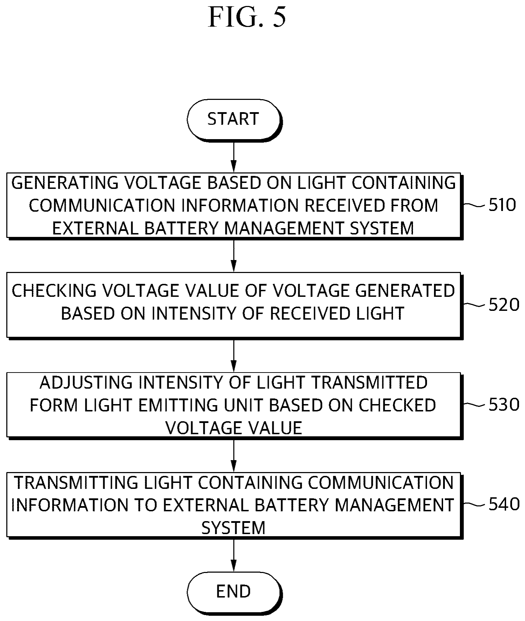

FIG. 5 is a flowchart illustrating an operation of the battery management system 100 that performs optical feedback wireless communication according to an embodiment.

Referring to FIG. 5, in step 510, the battery management system 100, according to an embodiment, may first generate a voltage based on light containing communication information transmitted by the external battery management system 200, in response to light transmitted from the battery management system 100, to the external battery management system 200. For example, the battery management system 100 may receive light containing communication information from the external battery management system 200 by the light receiving unit 110 described in FIGS. 3a and 3b, and may generate a voltage based on the received light containing communication information.

In step 520, the control unit 120 of the battery management system 100, according to an embodiment, may check the voltage value generated by the light receiving unit 110, which corresponds to the intensity of the light received from the external battery management system 200, and is based on the intensity of light received from the external battery management system 200. For example, the battery management system 100 may compare a previously generated voltage value with a designated target voltage value as described in FIGS. 3a and 3b. When the difference between the two voltage values is greater than a predetermined specific value (for example, when the generated voltage value is smaller than a predetermined specific value by a specific limit or more), the battery management system 100 may determine that the intensity of the light containing communication information received from the external battery management system 200 by the light receiving unit 110 has weakened, and correspondingly, may confirm that the intensity of the light received from the external battery management system 200 has decreased.

In step 530, the control unit 120 of the battery management system 100, according to an embodiment, may adjust the intensity of light transmitted from the light emitting unit 130 of the battery management system 100 based on the checked voltage value. For example, the battery management system 100 may adjust the intensity of light transmitted from the light emitting unit 130 of the battery management system 100 to the external battery management system 200 using the first operational amplifier 410, PWM logic circuit 420, gate driver circuit 430, buck-boost converter circuit 440, and negative feedback circuit 450, which are included in the control unit 120, as described in FIGS. 4a and 4b. For example, when the checked voltage value has decreased, the control unit 120 of the battery management system 100 may control the intensity of light transmitted from the light emitting unit 130 to the external battery management system 200 to increase. According to an embodiment, the control unit 120 may create a lookup table in advance, in which the intensity of light transmitted to the external battery management system 200 corresponds to the degree of decrease in the checked voltage value, and then store the lookup table in a memory. The lookup table may then be used to generate a voltage signal capable of generating the required light intensity.

In step 540, the battery management system 100 may transmit light containing communication information to the external battery management system 200. For example, the battery management system 100 may transmit light, the intensity of which has been controlled by the control unit 120, to the external battery management system 200.

In this way, communication quality may be maintained at a constant level through the optical feedback process, even when the light transmission ability is reduced due to aging, dust, or condensation, of the light receiving unit 110 and light emitting unit 130 of the battery management system 100 and the light receiving unit 210 and the light emitting unit 230 of the external battery management system 200.

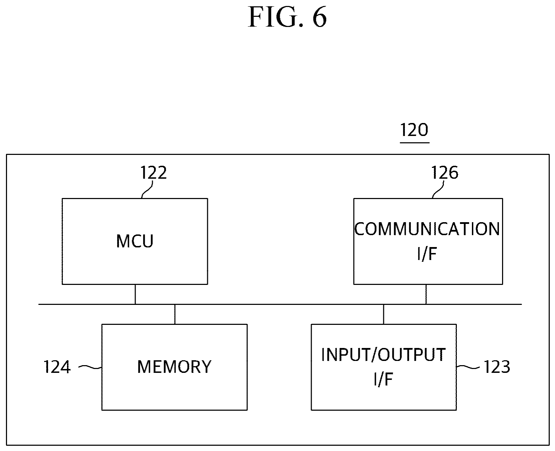

FIG. 6 is a block diagram illustrating a hardware configuration implementing the control unit 120 included in the battery management system 100 according to the present disclosure.

The control unit 120 according to an embodiment disclosed in this document may include a Micro Controller Unit (MCU) 122, a memory 124, a communication interface (I/F) 126, and an input/output interface (I/F) 128. The MCU 122 serves as a processor that executes various programs stored in the memory 124, processes various data used in these programs, and performs functions of the control unit 120.

The memory 124 may store operation data of various programs related to the operation of the battery management system for the operation of the control unit 120. The memory 124 may be provided in a plural number as needed. The memory 124 may be a volatile or a non-volatile memory. As a volatile memory, examples of the memory 124 may include a RAM, DRAM, SRAM, and others. As a nonvolatile memory, examples of the memory 124 may include a ROM, PROM, EAROM, EPROM, EEPROM, flash memory, and others. The listed examples of the memory 124 are merely illustrative and the memory 124 is not limited to these.

The communication I/F 126 is configured to be capable of transmitting and receiving various data to and from a server and may be any of various devices that may support wired and/or wireless communication. For example, the communication I/F 126 may transmit and receive programs or various data for the operation of the control unit 120 to and from an external server, which is separately provided, in a wired and/or wireless manner. The input/output I/F 128 may provide an interface that interconnects an input device (not illustrated) such as a keyboard, mouse, or touch panel, an output device (not illustrated), such as a display, and the MCU 122 to enable data transmission and reception therebetween.

The present embodiment may be represented by functional block configurations and various processing steps. These functional blocks may be implemented as any number of hardware and/or software configurations that perform specific functions. For example, the embodiments may employ direct circuit configurations, such as memory, processing unit, logic circuit, look-up table, and others, which may perform various functions under the control of one or more microprocessors or by other control devices. Similarly to how components may be implemented with software programming or software elements, the present embodiments may be implemented in a programming or scripting language such as C, C++, Java, or assembler, including various algorithms implemented as a combination of data structures, processes, routines, or other programming constructs. Functional aspects may be implemented as algorithms running on one or more processors. Additionally, the present embodiments may employ conventional techniques for electronic environment setting, signal processing, and/or data processing. Terms such as "mechanism", "element", "means", and "configuration", may be used broadly and are not limited to mechanical and physical configurations. The above terms may include the meaning of a series of software processes (routines) in connection with a processor, among others.

While the present disclosure has been described above with reference to several embodiments thereof, the present disclosure is not limited by the embodiments, and various changes and modifications may be made by a person ordinarily skilled in the art without departing from the technical spirit and equivalent scope of the present disclosure as defined by the appended claims.

## Claims

1. A battery management system comprising:
a light receiving unit configured to receive light containing communication information from an external battery management system and to generate a voltage corresponding to an intensity of the received light;
a light emitting unit configured to transmit light containing communication information to the external battery management system; and
a control unit,
wherein the control unit is configured to:
check a voltage value of the voltage generated by the light receiving unit based on the intensity of the light received from the external battery management system; and
adjust an intensity of the light transmitted from the light emitting unit based on the checked voltage value.

2. The battery management system according to claim 1, wherein the control unit controls the intensity of the light transmitted from the light emitting unit to the external battery management system to increase when the intensity of the light received from the external battery management system decreases.

3. The battery management system according to claim 1, wherein the control unit adjusts the intensity of the light transmitted from the light emitting unit to the external battery management system so that the checked voltage value is equal to a designated target voltage value.

4. The battery management system according to claim 3, wherein the designated target voltage value is determined based on communication consumption power between the battery management system and the external battery management system.

5. The battery management system according to claim 1, wherein the control unit includes:
a first operational amplifier configured to compare the checked voltage value with a designated target voltage value and output a duty voltage signal;
a pulse width modulation logic circuit configured to determine a duty ratio for the duty voltage signal;
a gate driver circuit connected to the pulse width modulation logic circuit and configured to control the duty ratio;
a buck boost converter circuit connected to the gate driver circuit and configured to output a feedback voltage signal based on a driving voltage and the duty ratio; and
a negative feedback circuit including a second operational amplifier and a MOSFET element to provide the feedback voltage signal to the light emitting unit.

6. The battery management system according to claim 5, wherein the first operational amplifier increases and outputs the duty voltage signal as a magnitude of a difference between the checked voltage value and the designated target voltage value increases.

7. The battery management system according to claim 5, wherein the buck-boost converter circuit increases and outputs the feedback voltage signal if the duty ratio increases.

8. The battery management system according to claim 5, wherein the negative feedback circuit provides the feedback voltage signal to the light emitting unit based on a current flowing through the MOSFET element.

9. The battery management system according to claim 5, wherein the MOSFET element is a PMOS element, and the second operational amplifier applies the feedback voltage signal to a drain terminal of the PMOS element.

10. An optical feedback communication method of a battery management system, the method comprising:
generating a voltage corresponding to an intensity of light received from an external battery management system based on the light containing communication information;
checking a value of the generated voltage;
adjusting an intensity of light transmitted from a light emitting unit based on the checked voltage value; and
transmitting light containing communication information to the external battery management system.

11. A battery management system comprising:
a light receiving unit configured to receive light containing communication information from an external battery management system and to generate a voltage corresponding to an intensity of the received light;
a light emitting unit configured to transmit light containing communication information to the external battery management system; and
a control unit,
wherein the control unit includes an optical feedback circuit configured to check a voltage value of the voltage generated by the light receiving unit based on the intensity of the light received from the external battery management system, and to adjust an intensity of the light transmitted from the light emitting unit based on the checked voltage value, and
wherein the optical feedback circuit includes a converter circuit configured to generate a variable voltage signal for a light signal to be transmitted from the light emitting unit to the external battery management system based on the checked voltage value.

12. The battery management system according to claim 11, wherein the optical feedback circuit further includes:
a first operational amplifier configured to compare the checked voltage value with a designated target voltage value and output a duty voltage signal;
a pulse width modulation logic circuit configured to determine a duty ratio for the duty voltage signal;
a gate driver circuit connected to the pulse width modulation logic circuit and configured to control the duty ratio; and
a second operational amplifier and a MOSFET element to provide a feedback voltage signal to the light emitting unit.
